# FASCICULE DE BREVET EUROPEEN

(11) **EP 3 047 528 B1**
(45) Date de publication et mention de la délivrance du brevet: **30.08.2017**
(21) Numéro de dépôt: 14777728.8
(22) Date de dépôt: 11.09.2014
(51) Int. Cl.: H01L 41/09, H01L 41/18, H01L 41/37, H01L 41/047, H01L 41/08, H01L 41/27

(54) **ACTIONNEUR PLAN PIÉZOÉLECTRIQUE À GRAND DÉPLACEMENT EN CISAILLEMENT**
PLANARER PIEZOELEKTRISCHER AKTOR MIT BREITER SCHERBEWEGUNG
PLANAR PIEZOELECTRIC ACTUATOR PROVIDING A LARGE SHEAR MOVEMENT

(30) Priorité: 20.09.2013 FR 1359055
(43) Date de publication de la demande: 27.07.2016
(73) Titulaire: Office National d'Etudes et de Recherches Aérospatiales (ONERA), 91120 Palaiseau (FR)
(72) Inventeur: MERCIER DES ROCHETTES, Hugues, F-59910 Bondues (FR); JOLY, Didier, F-59184 Sainghin en Weppes (FR)
(74) Mandataire: Gevers & Orès
(86) Numéro de dépôt international: PCT/FR2014/052249
(87) Numéro de publication internationale: WO 2015/040309

(56) Documents cités:
- EP-A1- 2 363 342
- US-A1- 2006 016 055

## Description

L'invention concerne un actionneur actif apte à fournir un déplacement plan de cisaillement. Elle vise plus particulièrement des actionneurs utilisant des fibres piézoélectriques.

Des actionneurs plats, formés à partir de couches de fibres piézoélectriques parallèles à une direction et prises en sandwich entre des couches porteuses d'électrodes orientées perpendiculairement à ces fibres pour les activer, ont déjà été développés pour faire glisser deux éléments de structure l'un par rapport à l'autre. Les applications visées en aéronautique sont par exemple la déformation contrôlée d'un élément aérodynamique pour l'adapter en fonction de ses variations d'incidence.

Dans ce type d'application, la performance de l'actionneur dans la direction de cisaillement est exprimée par la valeur de la distorsion angulaire correspondante.

La demanderesse a déjà proposé, dans le document FR 2 893 783, un actionneur plat rectangulaire produisant un cisaillement dans la direction de son bord long constitué d'une couche active de fibres piézoélectriques prises en sandwich entre deux couches porteuses d'électrodes parallèles, elles-mêmes recouvertes chacune d'une couche de tissu à chaîne et trame rigides orientées selon deux directions formant un maillage. La trame et la chaîne définissent un maillage de parallélogrammes déformables juxtaposés. Les fibres piézoélectriques forment un angle de 45° avec le bord long et de 90° avec les électrodes. Les différentes couches sont collées entre elles de manière à transmettre au mieux le déplacement en cisaillement de la couche plane de fibres piézoélectriques. Les couches de tissu à chaîne et trame rigides assurent la transmission du déplacement de cisaillement aux organes sur lesquels l'actionneur est installé et la rigidité du dispositif dans les autres directions.

L'inconvénient de ce dispositif est l'amplitude limitée de la distorsion angulaire que permet un module élémentaire de ce type d'actionneur. Quelque soit le matériau piézoélectrique utilisé dans les fibres, les essais réalisés par la demanderesse aboutissent à une distorsion angulaire moyenne de 1256 µdef à 45° pour une déformation de fibre de 800 µdef.

L'objet de l'invention est d'obtenir des valeurs de la distorsion angulaire beaucoup plus importantes avec un actionneur utilisant une couche de fibres piézoélectriques. Cela nécessite, d'une part d'augmenter la valeur de la distorsion angulaire produite par le mouvement des fibres piézoélectriques, d'autre part de garantir le niveau d'effort produit par l'actionneur dans la direction de cisaillement.

A cet effet, l'invention concerne un actionneur piézoélectrique à grand déplacement de cisaillement dans une direction choisie, présentant une structure en sandwich comportant au moins une couche active comportant des fibres piézoélectriques parallèles entre elles et inclinées par rapport à ladite direction, ladite couche active étant placée entre au moins deux couches porteuses d'électrodes disposées de manière à pouvoir provoquer sur commande une variation de longueur desdites fibres. Cet actionneur est remarquable en ce que :
- l'angle d'inclinaison desdites fibres par rapport à ladite direction choisie est supérieur à 2° et inférieur à 40° ;
- les espaces inter-fibres piézoélectriques de la couche active sont comblés par un matériau élastique, incompressible et de rigidité diélectrique supérieure à celle desdites fibres ;
- ladite couche active comporte au moins deux éléments dits éléments indéformables, ces éléments étant allongés, parallèles à ladite direction choisie et présentant un module de traction au moins égal à 200 GPa ;
- les extrémités de chaque dite fibre sont collées auxdits éléments indéformables à l'aide d'une colle rigide ;
- lesdits éléments indéformables sont collés, par une colle rigide, auxdites couches porteuses d'électrodes.

La combinaison des éléments indéformables et de la matrice constituée du matériau élastique incompressible dans les espaces inter-fibres permet de faire en sorte que la couche active réagit aux efforts de traction exercés dans son plan, sensiblement comme une succession de parallélogrammes déformables à bords rigides entre deux éléments indéformables.

Dans cette configuration, on peut montrer que le fait d'incliner les fibres piézoélectriques dans une direction inférieure à 40° par rapport à la direction des éléments indéformables permet d'obtenir des distorsions angulaires supérieures d'au moins un facteur 2 par rapport à l'inclinaison en diagonale à 45°.

Enfin, la transmission des efforts vers les organes sur lesquels s'applique l'actionneur, en passant par la couche porteuse d'électrodes, se fait entièrement au travers des éléments rigides, par les colles rigides. Ces éléments doivent donc présenter un grand module de traction pour résister sans se déformer aux efforts induits par les fibres. En contrepartie, ce mode de transmission supprime les pertes induites par la résistance au cisaillement dans les couches de colle chargées de transmettre les efforts entre les couches actives et les autres éléments du sandwich, telles qu'elles existent dans les réalisations antérieures.

Avantageusement, l'angle d'inclinaison desdites fibres piézoélectriques par rapport à la dite direction choisie est inférieur à 10°. En effet, la distorsion angulaire augmente très fortement lorsque l'inclinaison des fibres diminue et elle est théoriquement quatre fois supérieure à la valeur obtenue pour 45°, à partir de cette inclinaison.

De préférence, les fibres piézoélectriques sont reliées à la couche porteuse d'électrodes par un matériau élastique ayant un module de cisaillement inférieur à 10 MPa. Cette couche d'élastomère permet d'éviter des claquages électriques en maintenant sensiblement constante la distance entre les fibres piézoélectriques et les électrodes. Par contre, son faible module fait qu'elle oppose une faible rigidité en cisaillement au déplacement des fibres et qu'elle diminue donc peu l'effort exercé par l'actionneur.

De préférence, la couche porteuse d'électrodes est réalisée en matériau non conducteur fabriqué à partir de polyamide. Ce type de matériau supporte bien les cisaillements angulaires imposés par l'actionneur en fonctionnement.

Avantageusement, les deux bords de l'actionneur parallèles à la direction choisie de ladite couche active sont chacun formés par un desdits éléments indéformables. Cette configuration présente l'avantage, entre autres, que la transmission des déplacements aux organes actionnés peut être faite seulement par ces deux éléments indéformables.

L'invention concerne également un procédé pour réaliser un actionneur piézoélectrique à grand déplacement de cisaillement dans une direction choisie, présentant une structure en sandwich comportant au moins une couche active comportant des fibres piézoélectriques parallèles entre elles et inclinées par rapport à ladite direction, ladite couche active étant placée entre au moins deux couches porteuses d'électrodes disposées de manière à pouvoir provoquer sur commande une variation de longueur desdites fibres. Ce procédé est caractérisé par les opérations suivantes :
- Réalisation d'une dite couche active, par :
   ▪ Positionnement desdites fibres piézoélectriques avec un angle d'inclinaison supérieur à 2° et inférieur à 40° par rapport à ladite direction choisie ;
   ▪ Comblement des espaces inter-fibres piézoélectriques par un matériau élastique, incompressible et de rigidité diélectrique supérieure à celle desdites fibres ;
   ▪ Placement, parallèlement à ladite direction choisie, d'au moins deux éléments dits éléments indéformables, ces éléments étant allongés et présentant un module de traction au moins égal à 200 GPa ;
   ▪ Collage, par une colle rigide, des extrémités de chaque dite fibre aux dits éléments indéformables ;
- Collage, par une colle rigide, desdits éléments indéformables aux dites couches porteuses d'électrodes.

Avantageusement, l'étape de positionnement des fibres piézoélectriques est réalisée en sciant une plaque du matériau composant lesdites fibres piézoélectriques fabriquée sensiblement aux dimensions de la couche active.

De préférence, le placement des éléments indéformables est fait à l'intérieur de rainures pratiquées suivant la direction de cisaillement dans une plaque sensiblement aux dimensions de la couche active composée, sur toute son étendue, des fibres piézoélectriques séparées par des bandes de matériau élastique .

Selon ces deux dernières caractéristiques, la réalisation d'un bloc permet d'économiser du temps tout en assurant un positionnement régulier des éléments et une homogénéité de l'actionneur sur sa surface.

L'invention concerne également un élément aérodynamique déformable au moins partiellement comportant un actionneur piézoélectrique tel que décrit précédemment.

La présente invention sera mieux comprise et d'autres détails, caractéristiques ou avantages de la présente invention apparaîtront plus clairement à la lecture de la description qui suit, en référence aux dessins annexés sur lesquels :
La figure 1 présente schématiquement la structure en couches superposées d'un actionneur plan rectangulaire selon l'invention.
La figure 2 présente schématiquement un éclaté des différentes couches composant l'actionneur.
La figure 3 montre un détail schématique de la couche active contenant les fibres piézoélectriques.
La figure 4 montre un détail schématique de la couche intermédiaire assurant la liaison entre la couche active et la couche porteuse d'électrodes.
La figure 5 illustre schématiquement la déformation théorique d'un cadre rigide articulé soumis à une élongation de sa diagonale.
La figure 6 montre une comparaison schématique entre les distorsions angulaires d'un cadre rigide (C1) et d'un sandwich formé de deux barres rigides reliées par un élastomère (C2) obtenues pour différentes valeurs d'inclinaison de la diagonale.
La figure 7 présente schématiquement les étapes de fabrication d'un actionneur selon l'invention.

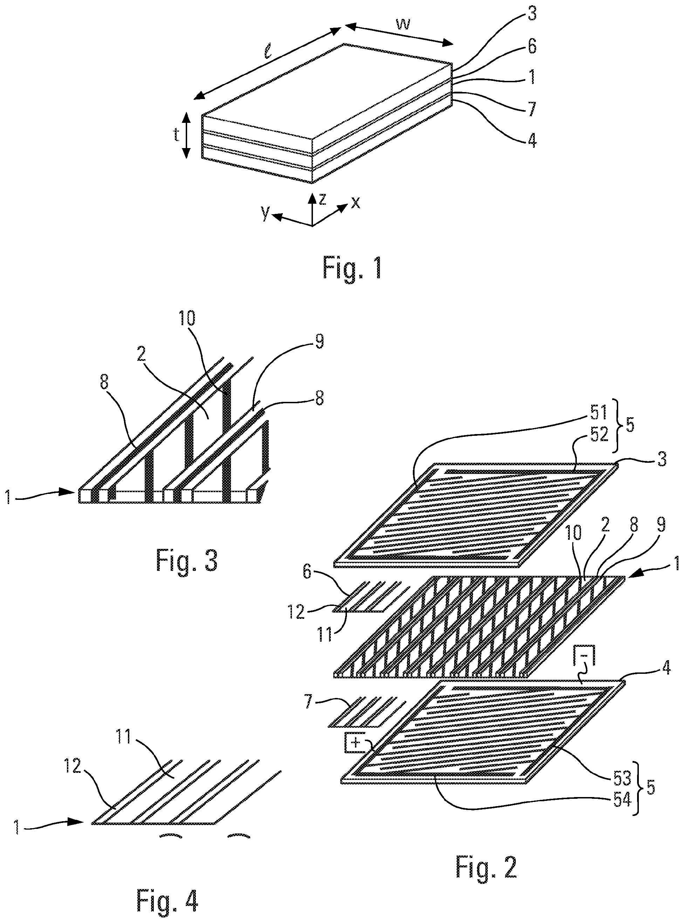

Un exemple d'actionneur plan, présenté sur la figure 1, a une forme rectangulaire d'épaisseur t suivant la direction Z, de longueur l suivant la direction X, qui représente sa plus grande dimension, et de largeur w selon la direction Y. Cet actionneur a une structure sandwich composée des éléments suivants :
- dans le plan central XY, une couche 1 comportant les fibres piézoélectriques 2,
- des couches planes, 3 et 4, portant les électrodes 5 activant les fibres piézoélectriques 2 placées de part et d'autre dans la direction Z et,
- des couches intermédiaires, 6 et 7, de colle assurant la liaison entre la couche centrale et les couches porteuses d'électrodes.

La couche centrale 1 (figure 2) est composée d'une alternance dans la direction Y de bandes comprenant les fibres piézoélectriques 2 et de barres filiformes 8. Chaque bord long, dans la direction X, de la couche centrale 1 est constitué par une barre filiforme. Cette couche est, de préférence, épaisse d'environ 180 µm.

Les barres filiformes 8 sont de section rectangulaire, d'une largeur de l'ordre de 350 µm, parallèles au bord long dans la direction X et espacés, par exemple, de 1 à 2 mm. Ces barres filiformes 8 sont en matériaux hautement isolants et de haut module de traction, au moins égal à 200 GPa, ce qui en fait des éléments indéformables. Des matériaux à haute rigidité diélectrique et haut module de traction tels que le carbure de silicium et le bore sont préférentiellement utilisés.

Entre ces barres filiformes 8, des fibres piézoélectriques 2 de section rectangulaire sont disposées faisant un angle θ avec la direction X. Cet angle est choisi dans l'intervalle compris entre 2° et 40°. Les propriétés de l'actionneur en fonction de la valeur choisie sont exposées plus tard, lors de la description de son fonctionnement. Par exemple, la largeur de ces fibres est de l'ordre de 150 µ. Le matériau de ces fibres 2 est du type MFC (Macro Fiber Composite), à prendre de préférence dans la liste suivante : PZT-SA, PZT-5H ou PMN-32% PT single crystal.

Les fibres piézoélectriques 2 sont collées à leur deux extrémités aux barres filiformes 8 avec de la colle rigide Epoxy 9.

L'intervalle entre deux fibres 2 est rempli d'un élastomère 10, de préférence incompressible, à faible module de cisaillement, préférentiellement inférieur à 20 MPa. La rigidité diélectrique de cet élastomère 10 est également, de préférence, supérieure à celle des fibres piézoélectriques 2. La largeur de la bande d'élastomère 10 entre deux fibres 2 est, de préférence, d'environ 55 µ. La largeur minimale de ces intervalles est limitée d'une part par la nécessité que l'élastomère supporte la déformation de l'actionneur, d'autre part par la rigidité diélectrique de cet élastomère 10 de manière à ce qu'il n'y ait pas de claquage électrique entre les zones à polarités opposées sur les fibres piézoélectriques 2.

Les couches planes 3, 4 portant les électrodes 5 sont formées d'un film fin de matériau en polyamide de type Kapton (marque déposée). De préférence, l'épaisseur du film est d'environ 0,3mm. Les électrodes sont noyées dans le film de la couche plane et sont formées de deux séries d'électrodes (51 et 52 pour la couche supérieure 3, 53 et 54 pour la couche inférieure 4) allongées et inter-digitées. Ces électrodes 5 sont orientées perpendiculairement aux fibres piézoélectriques 2.

Les couches intermédiaires, 6 et 7, assurant la liaison entre la couche 1 de fibres piézoélectriques et les couches, 3 et 4, porteuses d'électrodes, sont composées, ainsi que c'est représenté sur la figure 3, de bandes parallèles dans la direction X :
- au niveau de l'espace occupé par les fibres piézoélectriques 2, par un élastomère 11 de bas module de cisaillement, typiquement inférieur à 10MPa ;
- au niveau des barres filiformes 8, par une colle rigide de type Epoxy.
L'épaisseur de ces couches, par exemple de l'ordre de 20 µ, est limitée à ce qui est nécessaire pour assurer la liaison rigide entre les barres filiformes 8 et les couches porteuses d'électrodes, 4 et 5.

Le fonctionnement de l'actionneur selon l'invention est tel que lorsque les fibres piézoélectriques 2 sont mises sous tension au moyen des électrodes inter-digitées, 51, 52, 53 et 54, solidaires des couches porteuses d'électrodes, 4, et 5, en Kapton, les fibres 2 s'allongent en prenant appui à chacune de leurs extrémités sur les barres filiformes 8 qui se déplacent en sens opposés.

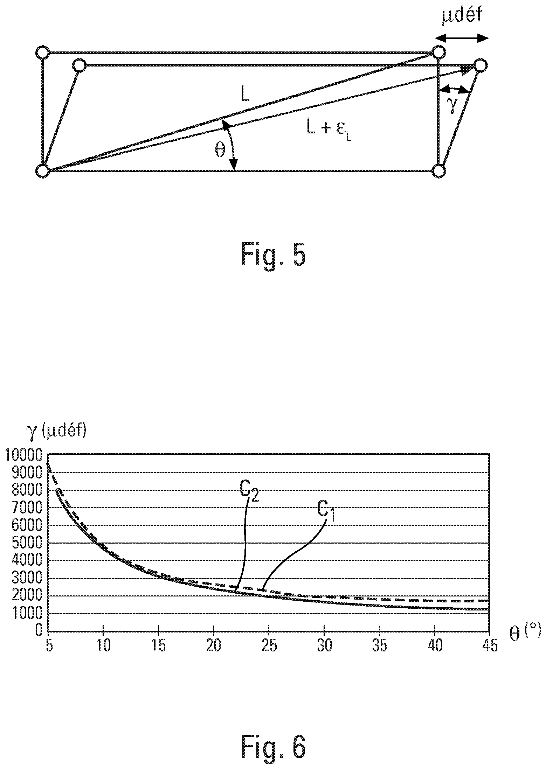

De manière remarquable, l'ensemble formé par les barres filiformes 8 et l'élastomère 10 placé entre les fibres piézoélectriques 2 se comporte sensiblement comme un cadre déformable ayant ses bords rigides, dont la diagonale est inclinée d'un angle θ par rapport aux bords longs constitués de barres filiformes 8. Lorsqu'un tel cadre, représenté sur la figure 5, est soumis à une déformation longitudinale ε_{L} imposée dans la direction de sa diagonale, la distorsion angulaire obtenue γ croît très vite lorsque l'inclinaison θ de cette diagonale diminue. La figure 6 montre une comparaison de la valeur de la distorsion angulaire γ obtenue pour une déformation ε_{L} valant 800 µdef, avec un cadre rigide par un calcul analytique (C₁), et avec un cadre constitué de deux éléments rigides reliés par un élastomère semblable à celui utilisé entre les fibres piézoélectriques 2 par un calcul numérique (C₂). Les résultats de distorsions angulaires très proches montrent que la couche active 1 peut se comporter sensiblement comme un cadre rigide articulé grâce à l'élastomère 10 situé entre les fibres 2.

D'autre part ces résultats illustrent que, pour un allongement donné des fibres piézoélectriques 2, on peut obtenir des distorsions angulaires nettement plus importantes lorsque l'inclinaison des fibres est faible. De plus, ce cisaillement est transmis aux couches porteuses d'électrodes en Kapton car elles sont collées aux barres filiformes 8 par la colle époxy 12 à haut module de rigidité.

Par ailleurs, l'allongement des fibres est d'autant plus important que les efforts s'y opposant sont faibles. Le cisaillement créé par l'actionneur en son centre est donc d'autant plus important que :
- le module de cisaillement de l'élastomère 9 entre les fibres piézoélectriques 2 est faible, diminuant ainsi la rigidité du cadre formé avec les barres filiformes 8 ;
- le module de cisaillement de l'élastomère 11, reliant les fibres 2 aux couches porteuses d'électrodes 3 et 4, est faible, diminuant ainsi l'influence de la rigidité des couches porteuses d'électrodes sur la déformation des fibres piézoélectriques.

Compte tenu de l'évaluation de la rigidité de l'ensemble s'opposant au travail des fibres 2 et de la valeur de la distorsion angulaire γ pour de faibles angles θ, un actionneur selon l'invention est préférentiellement réalisé avec une inclinaison des fibres inférieure à 10°. Cependant, plus cet angle est faible, plus le nombre de fibres 2 est faible pour une surface d'actionneur donnée. Il apparaît donc qu'il y aura une valeur en dessous de laquelle l'effort exercé par les fibres ne sera plus suffisant pour vaincre le cisaillement de l'élastomère 9 entre les barres filiformes 8. C'est pour cela qu'il est fixé ici une limite inférieure de 2° à cette inclinaison pour une réalisation pratique.

Afin d'illustrer les performances que l'on peut attendre d'un capteur selon l'invention, des calculs ont été réalisés pour modéliser la réponse d'un module élémentaire formé de deux barres filiformes 8 reliées par des fibres piézoélectriques inclinées à 10°. Les deux modules diffèrent par leurs longueurs et leurs largeurs : 5,2 x 1,2 mm pour le premier, 10,5 x 2,2 mm pour le second. Sinon, leurs autres caractéristiques, résumées dans le tableau ci-dessous sont identiques :

| | |
|---|---|
| Epaisseur de la couche active 1 | 180 µ |
| Epaisseur des couches porteuses d'électrodes 3 et 4 | 20 µ |
| Epaisseur des couches de liaison 6 et 7 | 30 µ |
| Module de cisaillement de l'élastomère (polyol) 10 entre les fibres adjacentes, et 11 entre les fibres et les couches porteuses d'électrodes | 0,1 MPa |
| Module de cisaillement de la colle époxy 9 entre les barres | 1200 MPa |
| filiformes et les fibres, et 12 entre les barres filiformes et les couches en Kapton. | |
| Module de traction du matériau (acier) des barres filiformes 8 | 210 GPa |

Les autres caractéristiques dimensionnelles sont celles déjà citées comme exemple dans la description du mode de réalisation. Les fibres piézoélectriques 2 sont en PZT5A de 1000Volts de manière à obtenir un allongement de fibre, noté ε_{L}, de l'ordre de 800µdef. Les couches, 3 et 4, porteuses des électrodes sont en Kapton.

La distorsion angulaire est évaluée au centre du film de Kapton formant une couche 3 porteuse d'électrodes. Cette valeur est comparée à celle obtenue avec un capteur selon l'état de l'art, dont les fibres sont inclinées à 45° et également sollicitées avec une tension de 1000V. Ce capteur a une longueur de 85 mm et une largeur de 28 mm. Les résultats sont reportés dans le tableau ci-dessous :

| Type d'actionneur | Orientation des fibres | Allongement des fibres ε_{L} | Distorsion angulaire du Kapton γ | Gain |
|---|---|---|---|---|
| Etat de l'art | 45° | 800 µdef | 1200 µdef | 1 |
| Premier module | 10° | ≈800 µdef | 2360 µdef | 2 |
| Deuxième module | 10° | ≈800 µdef | 2450 µdef | 2 |

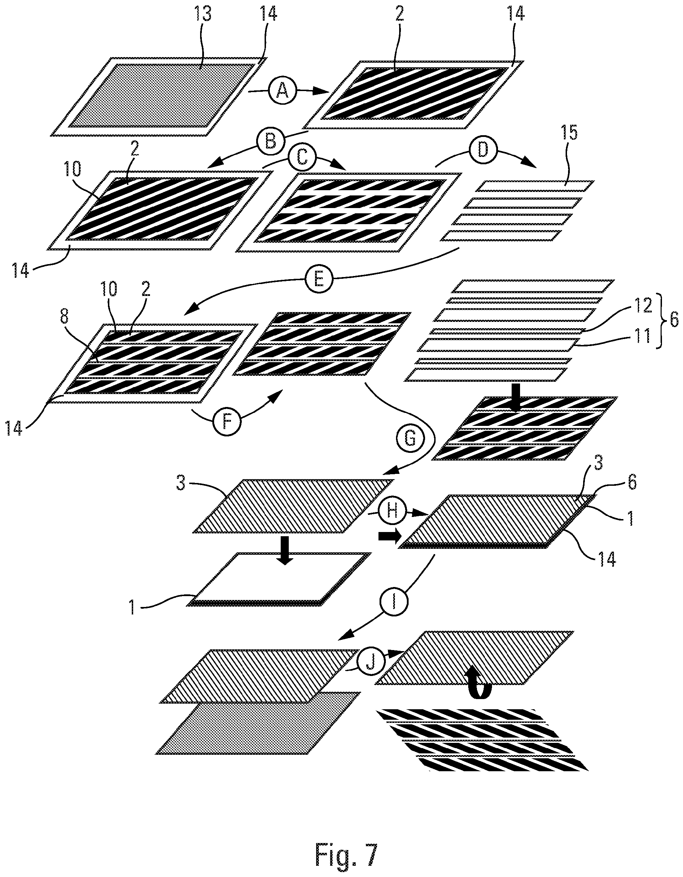

Par ailleurs, le procédé de fabrication de l'exemple d'actionneur précédemment décrit est illustré sur la figure 7. Il utilise au départ une plaque 13 de PZT collée à un film polymère 14, telle qu'elle peut être obtenue par un procédé de fabrication connu. Cette plaque est aux dimensions de la couche active 1 de l'actionneur finalement réalisé.

Une première étape A consiste à scier cette plaque pour former des bandes parallèles 2 de fibres piézoélectriques, inclinées d'un angle θ par rapport au bord long de la plaque. L'écartement des fibres 2 correspond à leur écartement dans l'actionneur. Par ailleurs, on évite de scier complètement le film polymère 14 soutenant l'ensemble.

Dans une étape B, on remplit les interstices entre les fibres piézoélectriques 2 avec l'élastomère 10 de la couche active 1.

Dans une étape C, on scie dans le sens de la longueur l'ensemble, fibres 2 et élastomère 10, sans attaquer le film polymère 14, pour former des rainures longitudinales en autant d'emplacements qu'il y aura de barres filiformes 8.

L'étape D consiste à déposer un cache 15 de protection sur les bandes longitudinales comportant les fibres 2.

L'étape E consiste à mettre en place les barres filiformes 8 dans les emplacements longitudinaux et à les coller aux fibres piézoélectriques 2 avec la colle époxy 9.

L'étape F consiste à extraire les caches 15 de protection.

L'étape G consiste à mettre en place sur la face supérieure de la couche active 1 ainsi créée, les films de colle époxy 12 en regard des barres filiformes 8 et les films d'élastomère 11 en regard des bandes contenant les fibres piézoélectriques 2.

L'étape H consiste à mettre en place la couche 3 porteuse d'électrodes avec ses électrodes 5, puis à la lier à la couche active 1 par une polymérisation des films 12 et 11.

Lors d'une étape I, on extrait le film polymère, puis dans une étape J, on retourne les deux couches ainsi obtenues.

On effectue ensuite les étapes G et H sur l'autre côté de la couche active 1 pour mettre en place la deuxième couche 4 porteuse d'électrodes.

Ce type d'actionneur peut avantageusement être utilisé dans des applications aéronautiques, notamment, pour modifier la forme d'un élément aérodynamique. Par exemple, la demande de brevet FR 2 924 681 décrit la mise en oeuvre d'actionneurs plans insérés dans la structure d'une pale de voilure tournante pour la déformer en torsion par un coulissement relatif des parties situées autour d'une fente orientée sensiblement dans le sens de l'envergure. De plus le coulissement doit être commandé en amplitude au cours de la rotation de la pale. L'actionneur selon l'invention peut facilement se substituer à l'actionneur plan de type piézoélectrique déjà envisagé dans cette application. De manière générale, l'invention peut trouver son application chaque fois qu'une partie d'un élément aérodynamique doit effectuer des mouvements de glissement ou de rotation autour d'une position donnée et que l'encombrement alloué à l'actionneur est réduit.

## Revendications

1. Actionneur piézoélectrique à grand déplacement de cisaillement dans une direction choisie, présentant une structure en sandwich comportant au moins une couche active (1) comportant des fibres piézoélectriques (2) parallèles entre elles et inclinées par rapport à ladite direction, ladite couche active étant placée entre au moins deux couches (3, 4) porteuses d'électrodes (5) disposées de manière à pouvoir provoquer sur commande une variation de longueur desdites fibres (2), ledit actionneur étant **caractérisé en ce que** :
- l'angle d'inclinaison desdites fibres par rapport à ladite direction choisie est supérieur à 2° et inférieur à 40° ;
- les espaces inter-fibres piézoélectriques de la couche active sont comblés par un matériau élastique (10), incompressible et de rigidité diélectrique supérieure à celle desdites fibres ;
- ladite couche active comporte au moins deux éléments (8) dits éléments indéformables, ces éléments étant allongés, parallèles à ladite direction choisie et présentant un module de traction au moins égal à 200 GPa ;
- les extrémités de chaque dite fibre (2) sont collées auxdits éléments indéformables (8) à l'aide d'une colle rigide (9) ;
- lesdits éléments indéformables (8) sont collés, par une colle rigide (12), auxdites couches (4) porteuses d'électrodes.

2. Actionneur selon la revendication 1 **caractérisé en ce que** l'angle d'inclinaison desdites fibres piézoélectriques (2) par rapport à la dite direction choisie est inférieur à 10°.

3. Actionneur selon l'une des revendications précédentes **caractérisé en ce que** les fibres piézoélectriques (2) sont reliées à la couche (4) porteuse d'électrodes par un matériau élastique (11) ayant un module de cisaillement inférieur à 10 MPa

4. Actionneur selon l'une des revendications précédentes **caractérisé en ce que** la couche (4) porteuse d'électrodes est réalisée en matériau non conducteur fabriqué à partir de polyamide.

5. Actionneur selon l'une des revendications précédentes **caractérisé en ce que** les deux bords parallèles à la direction choisie de ladite couche active sont chacun formés par un desdits au moins deux éléments indéformables (8).

6. Procédé pour réaliser un actionneur piézoélectrique à grand déplacement de cisaillement dans une direction choisie, présentant une structure en sandwich comportant au moins une couche active (1) comportant des fibres piézoélectriques (2) parallèles entre elles et inclinées par rapport à ladite direction, ladite couche active (1) étant placée entre au moins deux couches (4) porteuses d'électrodes (5) disposées de manière à pouvoir provoquer sur commande une variation de longueur desdites fibres, ledit procédé étant **caractérisé par** les opérations suivantes :
- Réalisation d'une dite couche active (1), par :
▪ Positionnement desdites fibres piézoélectriques (2) avec un angle d'inclinaison supérieur à 2° et inférieur à 40° par rapport à ladite direction choisie ;
▪ Comblement des espaces inter-fibres piézoélectriques par un matériau élastique (10), incompressible et de rigidité diélectrique supérieure à celle desdites fibres ;
▪ Placement, parallèlement à ladite direction choisie, d'au moins deux éléments (8) dits éléments indéformables, ces éléments étant allongés et présentant un module de traction au moins égal à 200 GPa ;
▪ Collage, par une colle rigide (9), des extrémités de chaque dite fibre (2) auxdits éléments indéformables (8) ;
- Collage, par une colle rigide (12), desdits éléments indéformables (8) auxdites couches (4) porteuses d'électrodes (5).

7. Procédé selon la revendication 6 dans lequel l'étape de positionnement des fibres piézoélectriques (2) est réalisée en sciant une plaque (13) du matériau composant lesdites fibres piézoélectriques fabriquée sensiblement aux dimensions de la couche active (1).

8. Procédé selon l'une des revendications 6 ou 7 dans lequel le placement des éléments indéformables (8) est fait à l'intérieur de rainures pratiquées suivant la direction de cisaillement dans une plaque sensiblement aux dimensions de la couche active (1) composée, sur toute son étendue, des fibres piézoélectriques (2) séparées par des bandes de matériau élastique (10).

9. Elément aérodynamique déformable au moins partiellement comportant un actionneur piézoélectrique selon l'une des revendications 1 à 5.

## Patentansprüche

1. Piezoelektrischer Aktuator mit großer Scherverschiebung in einer gewählten Richtung, der eine Sandwichstruktur aufweist, die mindestens eine aktive Schicht (1) mit piezoelektrischen Fasern (2), die parallel zueinander und schräg zu der Richtung sind, aufweist, wobei die aktive Schicht zwischen mindestens zwei Schichten (3, 4) angeordnet ist, die Elektroden (5) tragen, die derart angeordnet sind, um auf Befehl eine Änderung der Länge der Fasern (2) verursachen zu können, wobei der Aktuator **dadurch gekennzeichnet ist, dass**:
- der Neigungswinkel der Fasern gegenüber der gewählten Richtung größer als 2° und kleiner als 40° ist;
- die Zwischenräume zwischen den piezoelektrischen Fasern der aktiven Schicht durch ein elastisches Material (10) aufgefüllt sind, das inkompressibel und von einer Durchschlagfestigkeit ist, die größer als jene der Fasern ist;
- die aktive Schicht mindestens zwei Elemente (8), die sogenannten formstabilen Elemente, aufweist, wobei diese Elemente parallel zu der gewählten Richtung verlängert sind und ein Zugmodul von mindestens gleich 200 GPa aufweisen;
- die Enden von jeder Faser (2) mittels eines festen Klebstoffs (9) an den formstabilen Elementen (8) angeklebt sind;
- die formstabilen Elemente (8) mittels eines festen Klebstoffs (12) an den Schichten (4), die Elektroden tragen, angeklebt sind.

2. Aktuator nach Anspruch 1, **dadurch gekennzeichnet, dass** der Neigungswinkel der piezoelektrischen Fasern (2) gegenüber der gewählten Richtung kleiner als 10° ist.

3. Aktuator nach einem der vorhergehenden Ansprüche, **dadurch gekennzeichnet, dass** die piezoelektrischen Fasern (2) mit der Schicht (4), die Elektroden trägt, durch ein elastisches Material (11) verbunden ist, das ein Schermodul von weniger als 10 MPa aufweist.

4. Aktuator nach einem der vorhergehenden Ansprüche, **dadurch gekennzeichnet, dass** die Schicht (4), die Elektroden trägt, aus einem nicht leitenden Material hergestellt ist, das aus Polyamid angefertigt ist.

5. Aktuator nach einem der vorhergehenden Ansprüche, **dadurch gekennzeichnet, dass** die zwei Ränder, die parallel zu der gewählten Richtung der aktiven Schicht sind, jeweils aus einem der mindestens zwei formstabilen Elementen (8) gebildet sind.

6. Verfahren zur Herstellung eines piezoelektrischen Aktuators mit großer Scherverschiebung in einer gewählten Richtung, der eine Sandwichstruktur aufweist, die mindestens eine aktive Schicht (1) mit piezoelektrischen Fasern (2), die parallel zueinander und schräg zu der Richtung sind, aufweist, wobei die aktive Schicht zwischen mindestens zwei Schichten (4) angeordnet ist, die Elektroden (5) tragen, die derart angeordnet sind, um auf Befehl eine Änderung der Länge der Fasern verursachen zu können, wobei das Verfahren durch die folgenden Vorgänge gekennzeichnet ist:
- Erstellen einer aktiven Schicht (1) durch:
• Positionieren der piezoelektrischen Fasern (2) mit einem Neigungswinkel, der größer als 2° und kleiner als 40° gegenüber der gewählten Richtung ist;
• Auffüllen der Zwischenräume zwischen den piezoelektrischen Fasern durch ein elastisches Material (10), das inkompressibel und von einer Durchschlagfestigkeit ist, die größer als jene der Fasern ist;
• Anordnen parallel zu der gewählten Richtung von mindestens zwei Elementen (8), den sogenannten formstabilen Elementen, wobei diese Elemente verlängert sind und ein Zugmodul von mindestens gleich 200 GPa aufweisen;
• Ankleben der Enden von jeder Faser (2) durch einen festen Klebstoff (9) an die formstabilen Elementen (8);
- Ankleben der formstabilen Elemente (8) durch einen festen Klebstoff (12) an die Schichten (4), die Elektroden (5) tragen.

7. Verfahren nach Anspruch 6, wobei der Schritt des Positionierens der piezoelektrischen Fasern (2) durchgeführt wird, indem eine Platte (13) des Materials gesägt wird, aus dem die piezoelektrischen Fasern bestehen, die im Wesentlichen mit den Abmessungen der aktiven Schicht (1) hergestellt wird.

8. Verfahren nach einem der Ansprüche 6 oder 7, wobei das Anordnen der formstabilen Elemente (8) im Inneren von Rillen erfolgt, die entlang der Scherrichtung in einer Platte im Wesentlichen mit den Abmessungen der aktiven Schicht (1) gebildet sind, die über ihre gesamte Ausdehnung aus den piezoelektrischen Fasern (2) gebildet ist, die durch Streifen von elastischem Material (10) getrennt sind.

9. Aerodynamisches Element, das mindestens teilweise verformbar ist, umfassend einen piezoelektrischen Aktuator nach einem der Ansprüche 1 bis 5.

## Claims

1. Piezoelectric actuator with a large shear movement in a chosen direction, having a sandwich structure comprising at least one active layer (1) comprising piezoelectric fibres (2) parallel to one another and inclined with respect to said direction, said active layer being placed between at least two layers (3, 4) carrying electrodes (5) disposed so as to be able to cause on command a variation in length of said fibres (2), said actuator being **characterised in that**:
- the angle of inclination of said fibres with respect to said chosen direction is greater than 2° and less than 40°;
- the spaces between piezoelectric fibres in the active layer are filled with an incompressible elastic material (10) with a dielectric strength greater than that of said fibres;
- said active layer comprises at least two elements (8) referred to as non-deformable elements, these elements being elongate and parallel to said chosen direction and having a tensile modulus of at least 200 GPa;
- the ends of each of said fibres (2) are adhesively bonded to said non-deformable elements (8) by means of a rigid glue (9);
- said non-deformable elements (8) are adhesively bonded, with a rigid glue (12), to said layers (4) carrying electrodes.

2. Actuator according to claim 1, **characterised in that** the angle of inclination of said piezoelectric fibres (2) with respect to said chosen direction is less than 10°.

3. Actuator according to either of the preceding claims, **characterised in that** the piezoelectric fibres (2) are connected to the electrode-carrying layer (4) by an elastic material (11) having a shear modulus of less than 10 MPa.

4. Actuator according to any of the preceding claims, **characterised in that** the electrode-carrying layer (4) is produced from a non-conductive material manufactured from polyamide.

5. Actuator according to any of the preceding claims, **characterised in that** the two edges parallel to the chosen direction of said active layer are each formed by one of said at least two non-deformable elements (8).

6. Method for producing a piezoelectric actuator with a large shear movement in a chosen direction, having a sandwich structure comprising at least one active layer (1) comprising piezoelectric fibres (2) parallel to one another and inclined with respect to said direction, said active layer (1) being placed between at least two layers (4) carrying electrodes (5) disposed so as to be able to cause on command a variation in length of said fibres, said method being **characterised by** the following operations:
- producing one said active layer (1), by:
▪ positioning said piezoelectric fibres (2) with an angle of inclination greater than 2° and less than 40° with respect to said chosen direction;
▪ filling the spaces between piezoelectric fibres with an incompressible elastic material (10) with a dielectric strength greater than that of said fibres;
▪ placing, in parallel with said chosen direction, at least two elements (8) from said non-deformable elements, these elements being elongate and having a tensile modulus of at least 200 GPa;
▪ adhesively bonding, with a rigid glue (9), the ends of each of said fibres (2) to said non-deformable elements (8);
- adhesively bonding, with a rigid glue (12), said non-deformable elements (8) to said layers (4) carrying electrodes (5).

7. Method according to claim 6, wherein the step of positioning the piezoelectric fibres (2) is performed by sawing a sheet (13) of the material making up said piezoelectric fibres manufactured substantially to the dimensions of the active layer (1).

8. Method according to either claim 6 or claim 7, wherein the non-deformable elements (8) are placed in grooves formed in the shearing direction in a sheet substantially to the dimensions of the active layer (1) composed, over its entire extent, of the piezoelectric fibres (2) separated by bands of elastic material (10).

9. At least partially deformable aerodynamic element comprising a piezoelectric actuator according to any of claims 1 to 5.
